# EUROPEAN PATENT SPECIFICATION

(11) **EP 0 776 029 B1**
(45) Date of publication and mention of the grant of the patent: **08.05.2002**
(21) Application number: 96118646.7
(22) Date of filing: 20.11.1996
(51) Int. Cl.: H01L 21/304, H01L 21/306

(54) **Improvements in or relating to semiconductor chip separation**
Verbesserungen in oder in Bezug auf Halbleiterchiptrennung
Améliorations dans ou relatives à la séparation de puces semi-conductrices

(30) Priority: 21.11.1995 US 7402
(43) Date of publication of application: 28.05.1997
(73) Proprietor: TEXAS INSTRUMENTS INCORPORATED, Dallas Texas 75265 (US)
(72) Inventor: Orcutt, John W., Richardson,TX 75080 (US)
(74) Representative: Schwepfinger, Karl-Heinz, Dipl.-Ing.

(56) References cited:
- EP-A- 0 305 204
- US-A- 4 604 161
- US-A- 5 272 114
- US-A- 5 418 190
- PATENT ABSTRACTS OF JAPAN vol. 016, no. 350 (M-1287), 28 July 1992 & JP 04 107155 A (ALPS ELECTRIC CO LTD), 8 April 1992,

## Description

### BACKGROUND OF THE INVENTION

### FIELD OF THE INVENTION

This invention relates to a method for separating semiconductor chips formed on a semiconductor wafer, and more particularly to a method of the type defined in the precharacterizing portion of claim 1.

### BRIEF DESCRIPTION OF THE PRIOR ART

Chips formed on a single wafer of semiconductor material have generally been scribed and separated in the prior art by one of several available procedures. These prior art procedures generally provide for attachment of the wafer to an adhesive handling film with subsequent fracturing taking place along "streets" between rows and columns of chips to separate the chips. The chips are then removed from the handling film and processed in standard manner.

Fracturing of the wafer has generally been accomplished by (1) laser scribing a depression in the wafer along the "streets" and then breaking the wafer the rest of the way, (2) sawing a depression in the wafer along the "streets and then breaking the wafer the rest of the way, or (3) sawing entirely through the wafer along the "streets".

A problem arising from the above described prior art techniques has been the large amount of semiconductor material or chip surface area wasted due to the large "street" widths required in order to prevent damage to chips during chip separation. In the case of fracturing by the procedures listed above as (1) and (2), there is the possibly that the break in the wafer below the depression will not be straight, resulting in chips of nonuniform dimensions. Also, sawing can cause fractures at the wafer surface, this being a source of defects and decreased yields when sawing takes place at the surface containing the electrical components.

A method of the type mentioned in the beginning is known from Patent Abstracts of Japan JP-A-04107155. This document discloses a technique to improve printing quality by accurately cutting the surface of a silicon substrate with grooves for cutting processes prepared beforehand by employing anisotropic etching to the surface side of the silicon substrate.

European Patent Application EP-A-0 305 204 discloses a process for forming individual dies wherein the active side of a wafer is etched to form small V-shaped grooves defining the die faces, relatively wide grooves are cut in the inactive side of the wafer opposite each V-shaped groove, and the wafer cut by sawing along the V-shaped grooves, the saw being located so that the side of the saw blade facing the die is aligned with the bottom of the V-shaped groove so that there is retained intact one side of the V-shaped groove to intercept and prevent cracks and chipping caused by sawing from damaging the die active surface and any circuits thereon.

### SUMMARY OF THE INVENTION

In accordance with the present invention, there is provided a method for separating chips formed on and in semiconductor wafers of the type mentioned in the beginning and further comprising the features of the characterizing portion of claim 1.

In a preferred embodiment, trenches are etched in the wafer of semiconductor material, wherein etching takes place in standard manner with patterning and etching to define each chip area on the wafer surface, either at the commencement, during or after fabrication of the chips. Chip separation then involves securing the trench-containing surface to a die bonding adhesive tape and then sawing a groove from the reverse side in the direction of the trench spaced from the trench. Separation is completed by breaking. The saw or other groove-forming procedure is aligned with the trench at this time by passing a light to which the wafer is somewhat transparent, such as infrared in the case of a silicon wafer, through the masked wafer. This procedure minimizes the damage to the active surface of the chip caused by sawing on the chip surface containing the electrical components as practiced in the prior art.

### BRIEF DESCRIPTION OF THE DRAWINGS

The present invention will now be further described, by way of example, with reference to embodiments of the accompanying drawings in which:-
FIGURE 1 is a top view of a portion of a partially fabricated semiconductor wafer in accordance with the prior art;
FIGURE 2 is a cross sectional view taken along the line 2-2 of FIGURE 1; and
FIGURES 3 to 5 are a partial process flow for fabrication of semiconductor chips in accordance with the present invention.

### DESCRIPTION OF THE PREFERRED EMBODIMENT

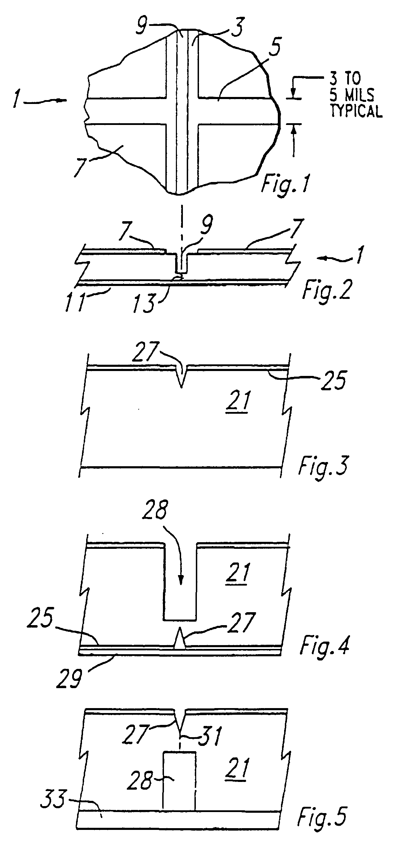

Referring first to FIGURES 1 and 2, there is shown a portion of a typical, partially fabricated prior art wafer 1 having "streets" 3 in the vertical direction and 5 in the horizontal direction defining chips or dice 7. The chips 7 are separated from each other by use of one of the above described prior art techniques which initially provides a cut 9 in the "street" 3 and a similar cut in the "street" 5 (not shown) followed by severing or breaking along the line 13. The "streets" 3 and 5 generally have a width in the range of about 3 to 5 mils to accommodate for some misalignment of the scribing apparatus as well as to minimize surface damage to the chip from sawing or the like. The prior art fabrication techniques involve securing the wafer to a handling film 11, which is generally a flexible film with an adhesive thereon, prior to commencement of any of the scribing operations as shown in FIGURE 2.

Referring now to FIGURES 3 to 5, there is shown a partial process flow for fabrication of chips in accordance with the present invention. In FIGURE 3, there is shown a cross section of a semiconductor wafer 21 in accordance with the present invention showing the wafer with the active surface 25 and a trench 27 which has been etched into the active surface of the wafer to define chips on the wafer.

The wafer 21 is secured by the active surface 25 thereon to a saw tape 29, which can be an adhesive material similar to the handling film and transmissive to the light frequencies to be passed therethrough as discussed hereinbelow if such light is utilized, as shown in FIGURE 4. A saw cut or groove 28 is then made which is aligned with the trench 27 and preferably extends to a small distance above the trench as shown in FIGURE 4. The groove 28 can extend to the trench 27 as an alternate embodiment. The light can be, for example, infrared light in the case of a silicon wafer since silicon is transparent to such light frequencies. The light or other aligning operation will be chosen to be compatible with the semiconductor wafer material being used to provide the alignment function.

The wafer 21 is then removed from the saw tape 29 and the surface with the groove 28 is again secured to a handling film 33, which can be an adhesive material similar to the handling film discussed hereinabove, and the chips are then separated by breaking or the like as in the prior art along the line 31 between trench 27 and groove 28 as shown in FIGURE 5. The breaking step is not required if the groove 28 has been sawed to contact the trench 27.

It can be seen that there has been provided a procedure for defining and separating chips fabricated on a wafer which requires far less spacing between chip areas than is required by prior art procedures, thereby saving surface areas and permitting more chips to be fabricated in the same wafer area compared with the prior art.

Though the invention has been described with reference to a specific preferred embodiment thereof, many variations and modifications will immediately become apparent to those skilled in the art.

## Claims

1. A method of separating chips on a semiconductor wafer (21) comprising the steps of
etching a pattern of intersecting trenches (27) on a selected surface (25) of said wafer (21) to define chip areas on said surface (25); and
forming a groove (28) extending from a surface of said wafer (21) opposing said selected surface (25) and aligned with said pattern of intersecting trenches (27); and
**characterized in that**
the method further comprises the step of breaking the region of semiconductor material in said wafer (21) between said groove (28) and said pattern of intersecting trenches (27) to form individual chips; and that
said step of forming a groove (28) comprises the steps of passing light having a frequency transmissive through said semiconductor wafer (21) from said trenches (27) through said semiconductor wafer (21) and forming said groove (28) aligned with said trenches (27).

2. The method of claim 1, wherein said step of etching a pattern includes the steps of masking said selected surface (25) to define a grid pattern and etching said grid pattern to form said trenches (27).

3. The method of claim 1 or claim 2, wherein said step of forming a groove (28) further comprises the step of adhering said wafer (21) to a tape (29) transmissive to light having said frequency prior to passing light through said wafer (21).

4. The method of any preceding claim, wherein said method further comprises the steps of securing said surface of said wafer (21) opposing said selected surface (25) to an adhesive surface before breaking the region of semiconductor material in said wafer (21), and removing said individual chips from said adhesive surface after breaking the region of semiconductor material in said wafer (21).

## Patentansprüche

1. Verfahren zum Trennen von Chips auf einem Halbleiterwafer (21) mit den Schritten:
Ätzen eines Musters einander schneidender Gräben (27) auf einer gewählten Fläche (25) des Wafers (21), um Chipflächen auf der Fläche (25) zu definieren, und
Bilden einer Rille (28), die sich von einer Fläche des Wafers (21), die der gewählten Fläche (25) gegenüberliegt und mit dem Muster einander schneidender Gräben (27) ausgerichtet ist, erstreckt, **dadurch gekennzeichnet, daß**
das Verfahren weiterhin den Schritt des Brechens des Bereichs des Halbleitermaterials in dem Wafer (21) zwischen der Rille (28) und dem Muster einander schneidender Gräben (27) zur Bildung einzelner Chips aufweist und daß
der Schritt des Bildens einer Rille (28) die Schritte des Hindurchführens von Licht mit einer vom Halbleiterwafer (21) durchgelassenen Frequenz von den Gräben (27) durch den Halbleiterwafer (21) und des Bildens der mit den Gräben (27) ausgerichteten Rille (28) aufweist.

2. Verfahren nach Anspruch 1, wobei der Schritt des Ätzens eines Musters die Schritte des Maskierens der gewählten Fläche (25) zum Definieren eines Gittermusters und des Ätzens des Gittermusters zum Bilden der Gräben (27) aufweist.

3. Verfahren nach Anspruch 1 oder 2, wobei der Schritt des Bildens einer Rille (28) weiter den Schritt des Klebens des Wafers (21) auf ein für Licht mit der Frequenz durchlässiges Band (29) aufweist, bevor Licht durch den Wafer (21) hindurchgeführt wird.

4. Verfahren nach einem der vorhergehenden Ansprüche, wobei das Verfahren weiter die Schritte des Befestigens der Fläche des Wafers (21), die der gewählten Fläche (25) gegenüberliegt, an einer Haftfläche, bevor der Bereich des Halbleitermaterials in dem Wafer (21) gebrochen wird, und des Entfernens der einzelnen Chips von der Haftfläche nach dem Brechen des Bereichs des Halbleitermaterials in dem Wafer (21) aufweist.

## Revendications

1. Procédé de séparation de puces d'une galette semi-conductrice (21) comprenant les étapes de :
Attaque d'une configuration de tranchées croisées (27) sur une surface sélectionnée (25) de ladite galette (21) afin de définir des zones de puces sur ladite surface (25) ; et
formation d'une gorge (28) s'étendant depuis une surface de ladite galette (21) opposée à la surface sélectionnée (25) et alignée avec ladite configuration de tranchées croisées (27) ; et **caractérisé en ce que** :
le procédé comprend en outre l'étape de rupture de la région du matériau semi-conducteur dans ladite galette (21) entre ladite gorge (28) et ladite configuration de tranchées croisées (27) pour former des puces individuelles ; et que
ladite étape de formation d'une gorge (28) comprend les étapes de passage de lumière ayant une fréquence transmissible à travers ladite galette semi-conductrice (21) depuis lesdites tranchées (27) à travers ladite galette semi-conductrice (21) et de formation de ladite gorge (28) alignée avec lesdites tranchées (27).

2. Procédé selon la revendication 1, dans lequel ladite étape d'attaque d'une configuration comporte les étapes de masquage de ladite surface sélectionnée (25) afin de définir une configuration de grille et l'attaque de ladite configuration de grille pour former lesdites tranchées (27).

3. Procédé selon la revendication 1 ou 2, dans lequel ladite étape de formation d'une gorge (28) comprend en outre l'étape d'adhésion de ladite galette (21) à une bande (29) de transmission de la lumière à ladite fréquence avant le passage de la lumière à travers ladite galette (21).

4. Procédé selon l'une quelconque des revendications précédentes, dans lequel ledit procédé comprend en outre les étapes de fixation de ladite surface de ladite galette (21) opposée à ladite surface sélectionnée (25) à une surface adhésive avant la rupture de la région du matériau semi-conducteur dans ladite galette (21), et de retrait desdites puces individuelles de ladite surface adhésive après rupture de la région du matériau semi-conducteur dans ladite galette (21).
